(19) Europäisches Patentamt
European Patent Office
Office européen des brevets

(11) Publication number: **0 044 136**
**B1**

(12) # EUROPEAN PATENT SPECIFICATION

(45) Date of publication of patent specification: **23.01.85**

(21) Application number: **81302606.9**

(22) Date of filing: **11.06.81**

(51) Int. Cl.⁴: **H 01 B 3/30**, C 08 L 81/02, H 01 L 23/30, H 01 C 1/02, H 01 G 1/02, H 01 H 9/02, H 04 R 1/28

(54) **Encapsulation of electronic device.**

(30) Priority: **04.07.80 JP 90714/80**

(43) Date of publication of application: **20.01.82 Bulletin 82/03**

(45) Publication of the grant of the patent: **23.01.85 Bulletin 85/04**

(84) Designated Contracting States: **DE FR GB NL**

(56) References cited:
**DE-A-2 500 789**
**GB-A-1 526 159**
**JP-A-52 149 348**
**JP-A-53 022 363**
**JP-A-53 066 565**
**JP-A-54 155 300**
**US-A-3 998 767**

(73) Proprietor: **ASAHI GLASS COMPANY LTD.**
**No. 1-2, Marunouchi 2-chome**
**Chiyoda-ku, Tokyo (JP)**

(72) Inventor: **Yanase, Hiroshi**
**No. 62, Kuritaya**
**Kanagawa-ku Yokohama-shi Kanagawa-ken (JP)**
Inventor: **Kanno, Fukuo**
**No. 543, Sanmaicho**
**Kanagawa-ku Yokohama-shi Kanagawa-ken (JP)**
Inventor: **Abe, Takeshi**
**547-114, Shiranecho**
**Asahi-ku Yokohama-shi Kanagawa-ken (JP)**

(74) Representative: **Warden, John Christopher et al**
**R.G.C. Jenkins & Co. 12-15, Fetter Lane**
**London EC4A 1PL (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 044 136 B1

**Description**

The present invention relates to the encapsulation of electronic devices. More particularly, it relates to encapsulation by a molding process with a compound comprising polyphenylene sulfide.

It is known to encapsulate electronic devices with synthetic resins in various fields for the purposes of electric insulation, mechanical protection and prevention of characteristic deterioration in the manufacture of integrated circuits, transistors, diodes, coils, capacitors, resistors, varistors and connectors. Thermosetting resins such as epoxy resin and silicon resins have been used as the synthetic resin. The encapsulation has been carried out by a casting process, a potting process, a dipping process and a molding process. The molding process, e.g. transfer molding or injection molding is the most advantageous because the operation is very efficient and precise and the synthetic resins are handled easily. In general, such molding processes require high molding pressures and are difficult to apply to the encapsulation of fine electronic devices.

In order to overcome such difficulties, a synthetic resin having high melt flow property and low melt viscosity is required. Thermosetting resin compounds such as epoxy or silicone compounds having low melt viscosity have been developed and used for encapsulation by the molding process.

These thermosetting compounds still have disadvantages in that a toxic crosslinking agent is used; a complicated formulation is required comprised of many kinds of additives; handling of the liquid resin is troublesome; the storage stability of the compounds is not satisfactory; a long molding time is required to cure the resin chemically in a mold; flash is not easily removed; and the mold is not easy to clean. Therefore encapsulation with a thermoplastic resin compound has been desired.

The facts that polyphenylene sulfide is a suitable thermoplastic resin for encapsulation and various disadvantages caused by the conventional thermosetting compounds can be overcome by using thermoplastic compounds comprising polyphenylene sulfide and a filler have been disclosed in Japanese Unexamined Patent Publication No. 149348/1977; No. 22363/1978 and No. 66565/1978 (Asahi Glass).

It is also known from GB—A—1526159 to include in such a polyphenylene/filler composition a silane in an amount of 0.5 to 5 weight percent to improve the water resistance of the composition and stabilise its linear coefficient of expansion.

The inventors have further studied the industrial application of encapsulation with these compounds and have found that the handling of the compounds is easy and molding properties are excellent in the encapsulation process and the molded products have excellent mechanical properties and electric properties. However, the electrical resistance of the molded product in a humid environment is not satisfactory. If the electronic part is encapsulated with a polyphenylene sulfide compound by the known method and exposed to a highly humid environment, it is found that moisture penetrates along the interfaces between the leads and the encapsulation material to cause current leakage, corrosion and in extreme cases, a disconnection of the circuit.

This problem has been solved by the invention in accordance with which there is provided a method of encapsulating an electronic device with a thermoplastic synthetic resin composition in which the encapsulation is carried out by a transfer molding process or an injection molding process, and the composition comprises polyphenylene sulfide of low viscosity under molding conditions together with a filler at a ratio of 1:4 to 4:1 characterised in that there is included in the composition an uncurable or incompletely curable tacky or adhesive polymer in a ratio of 0.1 to 50 wt. parts per 100 wt. parts of polyphenylene sulfide.

Embodiments of the invention are described hereafter.

In the drawings:—

Figure 1 is a plane view of a specimen device made in accordance with the invention for testing electrical resistance in a humid environment;

Figure 2 is a front view of said specimen; and

Figure 3 shows a test method for evaluation of the electrical resistance.

In the drawings, the reference 1 designates a metallic substrate and 2 designates the encapsulation material.

The polyphenylene sulfide (PPS) used in the present invention is a thermoplastic resin having the formula

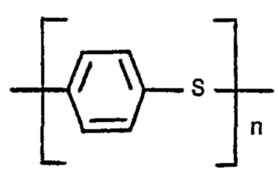

and is moldable in the same manner as other thermoplastic resins.

PPS is thermally stable up to a temperature of 260°C, is chemically inert, is non-flammable, is a good insulator, has a low dielectric loss tangent, has high strength and hardness similar to that of metals. PPS is classified into non-crosslinked PPS and crosslinked PPS. The melt viscosity of PPS increases with an increase in the degree of crosslinkage. The melt viscosity of the non-crosslinked PPS, measured by a die having a diameter of 0.5 mm and a land length of 1.0 mm at 300°C under an extrusion pressure of 30 $kg/cm^2$, is $3\times10^3$ poise or lower. The lower crosslinked PPS used in the present

invention has a melt viscosity of $3\times10^4$ poise or lower, preferably $5\times10^3$ poise or lower.

A well known commercially available PPS called Ryton is manufactured by Phillips Petroleum Co. "Ryton" PPS is classified into 5 types called V-1, P-2, P-3, P-4 and R-6 depending upon its degree of crosslinkage. The optimum grades for low melt viscosity are V-1, which has no crosslinking, and P-2 and P-3 which have a low degree of crosslinking.

In the present invention, V-1, P-2 and P-3 grades can be used separately or in continuation with one another. It is also possible to use a mixture of P-4 and V-1 grades. It is also possible to use PPS obtained by the heat-treatment of either partially crosslinked PPS or non-crosslinked PPS in the substantial absence of oxygen at a temperature of at least 290°C due to the ease of molding and physical properties of the molded product, which is described in Japanese Unexamined Patent Publication No. 155300/1979.

In the present invention, fillers are used to improve the dimensional stability, thermal conductivity and mechanical strengths of the molded products. Various fillers can be used, the choice not being critical. It is, however, undesirable to select fillers which decompose at the encapsulation molding temperature or which are electrical conductors or which can contain ionic impurities or those which are hygroscopic in order to maintain good electridal insulation of the compound. Various forms of fillers can be used such as powder, grain and fiber.

Suitable fillers in the form of powder or grain include silica powder, clay, calcined clay, calcium carbonate, talc, glass powder, glass beads, glass baloon, silica baloon, alumina and woolastonite. The best filler from these forms is silica powder having a high purity in view of its low coefficient of thermal expansion and absence of noxious ionic impurities. Suitable fillers in the form of fiber include inorganic fibers such as glass fiber, milled glass fiber, asbestos, and ceramic fiber, and heat resistant organic fibers such as aromatic polyamide fibers.

The best fiber fillers are glass fiber or milled glass fiber due to their availability and ease of handling. The filler used can be of one kind or a combination of two or more kinds. It is also possible to use a combination of fillers comprising a powder or grain form and a fiber form such as the combination of high purity silica powder and milled glass fiber.

It is preferable to treat the filler with a surface modifier such as a silicone coupling agent such as epoxysilane, aminosilane, mercaptosilane and vinylsilane or a titanate coupling agent so as to improve the affinity of the filler for the resin.

In the present invention, the ratio of polyphenylene sulfide to the filler is in the range of 1:4 to 4:1. When the ratio of the filler is less than the lower limit, the dimensional variation in the molding process is too much and the dimensional accuracy is too low and the thermal conductivity, mechanical strength and dimensional stability of the molded product are not satisfactory. When the ratio of the filler is more than the upper limit, the melt flow property of the compound is too poor to achieve a smooth encapsulation molding. Thus formulations that deviated from the range specified above are disadvantageous.

In the present invention, it is necessary to incorporate a specific amount of a tacky or adhesive polymer in the thermoplastic compound used in the encapsulation process. Such a polymer improves the adhesive properties of the encapsulation material to the circuit or the lead of an electronic device in the encapsulation process. The electrical resistance in a humid environment of the encapsuled electronic device is remarkably improved by the presence of the tacky or adhesive polymer.

In the present invention, it is preferable to use a tacky or adhesive polymer having a melting or softening point of 200°C or lower and a 5% weight loss temperature of at least 300°C measured at a temperature rising rate of 10°C/min in air. This is because such a polymer is easy to handle in the preparation of the compound pellets; has a reduced tendency to foam in the encapsulation process; or improves the electrical resistance of the composition in a humid environment. Optimum results are attained by using a polymer selected from the group consisting of phenoxy resins, epoxy resins and silicone resins.

Phenoxy resins suitable for use as the tacky or adhesive polymer in the present invention can be produced by using Bisphenol A and epichlorohydrine as main components. A similar method can be used to produce the epoxy resins except that the phenoxy resin lacks the terminal epoxy groups and is thermoplastic. It is preferable to use phenoxy resins, such as Bakelite (Trade Mark) manufactured by UCC in USA, which have a softening temperature of about 100°C and a molecular weight of about $2.5\times10^4$—$3.5\times10^4$.

The epoxy resins used in the present invention can be typical epoxy resins such as liner polycondensates of Bisphenol A and epichlorohydrine and modifications thereof using a halogenised Bisphenol A resorcine or Bisphenol F instead of Bisphenol A or Novolac type epoxy resins; polyalcohol type epoxy resins; and polyglycol type epoxy resins etc. Various solid epoxy resin prepolymers are obtained in the solution at room temperature, having a melting point of about 150°C which is dependent upon their molecular weight. It is preferable to use a solid one at room temperature having relatively a high molecular weight in view of their easy handling properties and reduced tendency to foam in the encapsulation process.

In the conventional process, it is usual to incorporate curing agents such as amines, acid anhydrides and polysulfides into the epoxy resin. In the process of the present invention, either no curing agent is incorporated, or only a small amount of the curing agent is incorporated so that there is insufficient for complete curing. If a large amount of a curing agent is incorporated, the epoxy resin component is hardened completely during the preparation of the compound pellets or in the mixing operation in a barrel before the encapsulation whereby the adhesive property of the component to an IC circuit or a lead in the encapsulation process is lost. When a curing agent is not incorporated or only a small amount of a curing agent is incorporated, the adhesive property of the component is maintained and the runner and sprue portions can be expected to be reused.

The silicone type polymers used in the present invention have a tacky or adhesive property. It is preferable to use commercially available silicone tackifiers and silicone adhesives as the basic resin components in the various formulations.

It is especially preferable to use silicone resins having a structural unit of

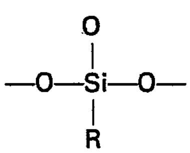

or modified silicone resins which are obtained by modifying said silicone resin by introducing linear segments having structure units of

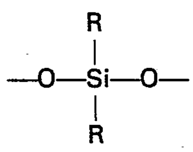

or chemically bonding an alkyd. Silicone type polymers having no tacky or adhesive property such as silicone oil, and condensates of silane coupling agents are not suitable.

In known processes, it is usual to incorporate a curing agent or a hardening catalyst into the silicone type polymer as in the case of the epoxy resin. In the process of the present invention, it is preferable that no curing agent is incorporated or only a small amount of a curing agent is incorporated in view of the same reasons described for the epoxy resins.

In the present invention, the tacky or adhesive polymer is incorporated at a ratio of 0.1 to 50 wt. parts preferably 0.5 to 20 wt. parts per 100 wt. parts of PPS. When the ratio of the tacky or adhesive polymer is too small, the effect of its addition is not satisfactory whereas when it is too much, rigidity of the molded product at high temperature is lost. Both of these effects are disadvantageous.

It is possible to incorporate small amounts of additives such as pigments and inner lubricants in the resin compounds of the present invention without deviating from the purposes for the present invention. The resin compound preferably has an apparent viscosity of $1 \times 10^2$ to $8 \times 10^3$ poise measured by using a die having a diameter of 0.5 mm and a land length of 1.0 mm under an extrusion pressure of 30 kg/cm$^2$ at 300°C; preferably it should have an apparent viscosity of $5 \times 10^3$ poise or lower measured under the same condition for the encapsulation of fine electronic device.

Various mixing processes can be used in the preparation of resin compounds in the present invention. The conventional dry or wet process used for mixing resin compounds can be employed. For example, a desired ratio of the filler and PPS can be mixed by a dry blend process in a V-shape blender or a Hemschel mixer. The mixture is then melt-extruded by an extrusion machine to mix the filler and PPS in a molten condition and to prepare pellets of the mixture. The pellets are then mixed with the tacky or adhesive polymer or a dispersion of solution thereof. When the dispersion or solution is used, the medium or solvent of the dispersion or solution is separated and the remainder is melt-extruded by an extrusion machine to prepare pellets containing all components. All of the components can also be mixed in an organic solvent or in an aqueous solution of a surface active agent.

The encapsulation of the present invention can be carried out by a molding process of a transfer molding process or an injection molding process. During the encapsulation process, the electronic device is kept in a mold and the mold is closed and the synthetic resin is charged and the mold is opened at the final stage of molding to take out the molded product. In the case of a thermosetting resin. the mold must be kept closed during the time required for curing after the charge of the resin however, in the case of a thermoplastic resin such as PPS, the molding time can be shortened because only the time needed for the composition to cool is required.

The condition for the molding is different depending upon the kind and shape of the electronic device and kind and ratio of the PPS and the filler. The molding process is usually carried out under the following condition.

Molding pressure:
5 to 100 kg/cm$^2$ preferably 10 to 50 kg/cm$^2$

Barrel temperature:
280 to 360°C preferably 300 to 350°C

Die temperature:
80 to 250°C preferably 130 to 220°C.

In the encapsulation process of the present invention, the tacky or adhesive polymer is used as one component in the thermoplastic compound so that the electrical resistance in a humid environment of the encapsulated product is remarkably improved without causing the problem of the encapsulated product sticking to the mold. The reason for this is not clear but the following hypothesis is offered. Only a relatively small adhesive force is required to inhibit the penetration of moisture along the interface between the resin compound matrix and the lead, the IC circuit or the metallic part because there is substantially no applied external force. Therefore, the adhesive property in the present invention causes no problems when the molded product is removed from the mold. Moreover, the solidification of the encapsulation product in the mold is initiated from the sides of the product in contact with the mold. The tacky or adhesive polymer incorporated has a lower melting point than that of the PPS causing the tacky or adhesive polymer to be concentrated in the central part of the product in the melting operation. The present invention is not limited by this hypothesis.

In accordance with the present invention, an encapsulation product having an excellent electrical resistance in a humid environment can be effectively molded and moreover, the runner and sprue portions can be recycled to provide excellent savings in the raw material used.

The present invention will be further illustrated by certain examples and references which are provided for purposes of illustration.

The methods of evaluation of the electrical resistance in a humid environment will be illustrated by referring to the drawings.

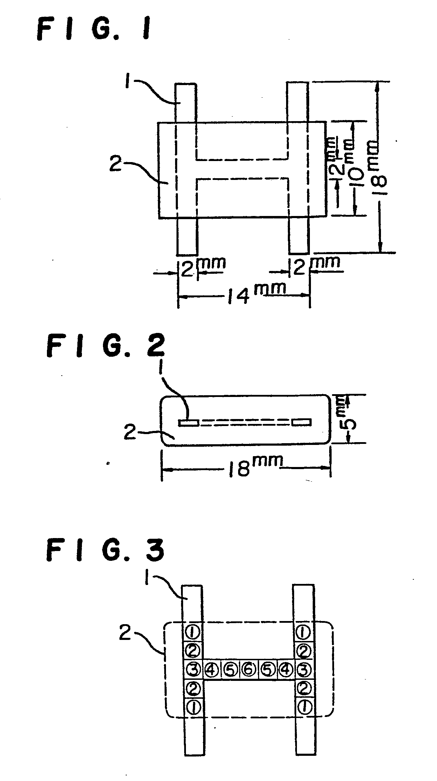

To evaluate the electrical resistance in a humid environment, the specimen shown in Figure 1 (plane view) and Figure 2 (front view) is prepared. In the drawings, reference 1 designates an aluminium plated iron-nickel alloy piece having a thickness of 0.3 mm and reference 2 designates a thermoplastic compound for encapsulation.

In the preparation of the specimen, an injection molding machine for inserted parts (manufactured by Toho Press Co. Ltd.; having a maximum clamping force of 20 ton; a maximum injection capacity of 80 $cm^3$; a screw diameter of 34 mm and a maximum injection pressure of 150 $kg/cm^2$) is used and a thermoplastic compound is fed into the mold with an alloy substrate previously set by an insert injection molding technique under the condition of a barrel temperature of 310°C; an injection pressure of 70 $kg/cm^2$; and a mold temperature of 150°C. The resulting specimen is boiled in an aqueous red ink (manufactured by The Pilot Pen Co. Ltd.) at a specific temperature for a specific period of time. The resin compound used in the encapsulation process is removed and the degree of penetration of the red ink is observed. The six sections ① to ⑥ shown in Figure 3 are set a distance of every 2 mm from the edge of the encapsulation. Section ⑥ designates the surface at the center of the encapsulated product.

Because of the experimental finding that the degree of penetration of the moisture from the edge of a lead of an electronic device in the encapsulation is highly related to the electrical resistance in a humid environment of the encapsulated product and that an increase in the electrical resistance in a humid environment is dependent upon a decrease in the penetration of the moisture, the electrical resistance of the encapsulated device in a humid environment is evaluated simply by measuring the penetration of the moisture.

Examples 1 to 3 and Reference 1

1.4 Kg of PPS (Ryton P-4; manufactured by Phillips-Petroleum Co.; which has a melt viscosity of 1900 poise measured at 300°C under a pressure of 50 $kg/cm^2$), 0.6 kg of PPS (Ryton V-1; a melt viscosity of 120 poise measured at 300°C under a pressure of 10 $kg/cm^2$), 1.0 kg of milled glass fibre (manufactured by Asahi Fiber Glass Co. Ltd. MF-A; a diameter of 10 $\mu$ and a length of 30 to 100 $\mu$) which was surface treated with an aminosilane surface treatment agent (manufactured by Nippon Unicar Co. A-1100) and 1.5 kg of silica powder having high purity (manufactured by Tatsumori Co. Ltd. Fuselex E-1; particle diameter of 1—50 $\mu$) which was surface treated by the same aminosilane were charged in a 10 liter V-shape blender. The mixture was blended at a rate of 60 rpm for 10 minutes. The mixture was charged into a monoscrew extrusion machine having a screw diameter of 40mm to extrude it at a barrel temperature of about 300°C and a dice temperature of about 300°C and at a screw rotation rate of 30 rpm so as to obtain pellets. The pellets had an apparent melt viscosity of 3000 poise at 300°C under an extrusion pressure of 30 $kg/cm^2$.

The resulting pellets were admixed in turn with a phenoxy resin, an epoxy resin and a silicone resin at a ratio of 5 wt. parts per 100 wt. parts of PPS to prepare pellets of each resin compound. A specimen to test the electrical resistance in a humid environment was prepared from the pellets of each resin compound. The tests for penetration of an aqueous red ink were carried out on five specimens from each resin compound, under the condition of boiling at 100°C for 72 hours. The results are shown in Table 1. As a control, specimens having no additional resin were also tested.

Phenoxy resin

Bakelite (TM) phenoxy resin PKHH grade manufactured by Union Carbide Co. molecular weight of 25,000—35,000; specific gravity of 1.17—1.19; softening temperature of 100°C; 5% weight loss temperature of 385°C.

Epoxy resin

Epicoat (TM) 1009 manufactured by Shell Petro. Co. melting point of 140—155°C; 5% weight loss temperature of 385°C thermoset adhesive agent solid at room temperature.

Silicone resin

Toshiba Silicone YR 3340 (manufactured by Toshiba Silicone Co. Ltd.) solution of 40 wt.% of silicone resin in a mixed solvent of toluene and xylene which has a viscosity of 120—160 poise at 25°C. In the example, the solvent was separated before addition to the PPS compound. The solid obtained by separating the solvent was a jelly at room temperature, having a 5% weight loss temperature of 325°C.

TABLE 1

| | Additional polymer | Degree of penetration of red ink |
|---|---|---|
| Example 1 | Phenoxy resin | to half of section ① |
| Example 2 | Epoxy resin | " |
| Example 3 | Silicone resin | " |
| Reference | none | sections ①—⑧ with deep coloring in sections ①—② |

Examples 4 to 7 and Reference 2

2.0 Kg of polyphenylene sulfide (PPS) (Ryton P-2 manufactured by Phillips-Petroleum Co.; which has a melt viscosity of 2500 poise measured at 300°C under a pressure of 10 kg/cm$^2$), 0.5 kg of milled glass fiber (manufactured by Asahi Fiber Glass Co. Ltd. MF-A) which was surface-treated in the same manner as Examples 1 to 3, and 2.5 kg of silica powder having a high purity (manufactured by Tasumori Co., Ltd. Fuselex E-1) which was surface-treated in the same manner as Examples 1 to 3 were blended with phenoxy resin (manufactured by Union Carbide Co. PKHH grade) at each of the ratios shown in Table 2, to prepare a series of differing PPS resin compounds.

Specimens to test the electrical resistance in a humid environment were prepared by molding pellets of each resin compound.

Five specimens for each resin compound were charged in the aqueous red ink in an autoclave and were immersed at 125°C under higher pressure for 7 days. After opening the autoclave the specimens were examined. The results are shown in Table 2.

As a control, specimens of encapsulated products having no phenoxy resin were also tested.

It is found that the electrical resistance in a humid environment is remarkably improved by the addition of the adhesive resin according to the present invention.

TABLE 2

| | Content of phenoxy resin (wt. part per 100 wt. part of PPS) | Degree of penetration (125°C:7 days) |
|---|---|---|
| Example 4 | 20 | to section ① |
| Example 5 | 5 | " |
| Example 6 | 2.5 | " |
| Example 7 | 0.5 | to section ① 3 spec<br>to section ② 2 spec |
| Reference | 0 | sections ①—⑥ |

## Claims

1. A method of encapsulating an electronic device with a thermoplastic synthetic resin composition in which the encapsulation is carried out by a transfer molding process or an injection molding process, and the composition comprises polyphenylene sulfide of low viscosity under molding conditions together with a filler at a ratio of 1:4 to 4:1 characterised in that there is included in the composition an uncurable or incompletely curable tacky or adhesive polymer in a ratio of 0.1 to 50 wt. parts per 100 wt. parts of polyphenylene sulfide.

2. A method according to claim 1 wherein said tacky or adhesive polymer has a melting point or softening point of 200°C or lower and a 5% weight loss temperature of at least 300°C measured at a temperature rising rate of 10°C/min in air.

3. A method according to claim 1 or 2 wherein said tacky or adhesive polymer is at least one selected from phenoxy resins, epoxy resins and silicone resins.

4. A method according to any preceding claim wherein said composition has an apparent viscosity of $1 \times 10^2$ to $8 \times 10^3$ poise measured by using a die having a diameter of 0.5 mm and a land length of 1.0 mm under an extrusion pressure of 30 kg/cm² at 300°C.

5. A method according to any preceding claim wherein said molding is carried out under a molding pressure of 5 to 100 kg/cm², a barrel temperature of 280 to 360°C and a die temperature of 80 to 250°C.

6. A method according to any preceding claim wherein at least part of said filler is a silica powder having high purity.

## Patentansprüche

1. Verfahren zur Umkapselung einer elektronischen Einrichtung mit einer thermoplastischen synthetischen Harzmasse durch eine Überführungsformverfahren oder Spritzgußverfahren, wobei die Masse Polyphenylensulfid mit einer unter den Formbedingungen niedrigen Viskosität zusammen mit einem Füllstoff im Verhältnis 1:4 bis 4:1 umfaßt, dadurch gekennzeichnet, daß die Masse ein nicht härtbares oder unvollständig härtbares klebriges oder haftendes Polymeres in einem Verhältnis von 0,1 bis 50 Gewichtsteilen pro 100 Gewichtsteile des Polyphenylensulfids enthält.

2. Verfahren nach Anspruch 1, dadurch gekennzeichnet, daß das klebirige oder haftende Polymere einen Schmelzpunkt oder Erweichungspunkt von bis zu 200°C aufweist und einem 5%igen Gewichtsverlust erst bei einer Temperatur von mindestens 300°C bei einer Temperaturerhöhungsgeschwindigkeit von 10°C/min an Luft erleidet.

3. Verfahren nach einem der Ansprüche 1 oder 2, dadurch gekennzeichnet, daß das klebrige oder haftende Polymere mindenstens ein Vertreter ausgewählt aus der Gruppe der Phenoxyharze, Epoxyharze und Silikonharze ist.

4. Verfahren nach einem der vorhergehenden Ansprüche, dadurch gekennzeichnet daß die Masse eine scheinbare Viskosität von $1 \times 10^2$ bis $8 \times 10^3$ Poise aufweist, gemessen mit einer Düse mit einem Durchmesser von 0,5 mm und einer Länge des erhabenen Bereichs von 1,0 mm unter einem Extrusionsdruck von 30 kg/cm² bei 300°C.

5. Verfahren nach einem der vorhergehenden Ansprüche, dadurch gekennzeichnet, daß der Formprozeß unter einem Formdruck von 5 bis 100 kg/cm² durchgeführt wird, wobei die Rohrtemperatur 280 bis 360°C beträgt und wobei die Düsentemperatur 80 bis 250°C beträgt.

6. Verfahren nach einem der vorhergehenden Ansprüche, dadurch gekennzeichnet, daß mindestens ein Teil des Füllstoffs aus Siliziumdioxidpulver mit hoher Reinheit besteht.

## Revendications

1. Procédé pour surmouler un dispositif électronique à l'aide d'une composition de résine synthétique thermoplastique, dans lequel le surmoulage est effectué par mise en oeuvre d'une opération de moulage par transfert ou d'une opération de moulage par injection, et la composition comprend du sulfure de polyphénylène ayant une faible viscosité dans les conditions du moulage, associé à une charge sous un rapport de 1:4 à 4:1 caractérisé en ce qu'il est incorporé dans la composition un polymère collant ou adhésif non-durcissable ou incomplètement durcissable, dans une proportion de 0,1 à 50 parties en poids pour 100 parties en poids de sulfure de polyphénylène.

2. Procédé selon la revendication 1, dans lequel ledit polymère collant ou adhésif possède un point de fusion ou un point de ramollissement égal ou inférieur à 200°C et une température de perte de poids de 5% d'au moins 300°C mesurée sous une vitesse d'élévation de la température de 10°C/mn à l'air libre.

3. Procédé selon la revendication 1 ou 2, dans lequel ledit polymère collant ou adhésif est constitué par au moins un composant choisi parmi les résines phénoxy, les résines époxy et les résines silicone.

4. Procédé selon l'une quelconque des revendications précédentes, dans lequel ladite composition a une viscosité apparente de $1 \times 10^2$ à $8 \times 10^3$ poises mesurée à l'aide d'une filière ayant un diamètre de 0,5 mm et une longueur de 1,0 mm, sous une pression d'extrusion de 30 kg/cm² à 300°C.

5. Procédé selon l'une quelconque des revendications précédentes, dans lequel ledit moulage est effectué sous une pression de moulage de 5 à 100 kg/cm², une température

de cylindre de 280 à 360°C et une température de filière de 80 à 250°C.

6. Procédé selon l'une quelconque des revendications précédentes, dans lequel au moins une partie de ladite charge est une poudre de silice ayant une pureté élevée.

FIG. 1

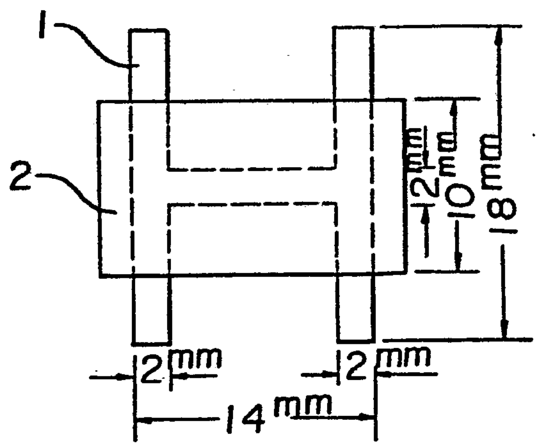


FIG. 2

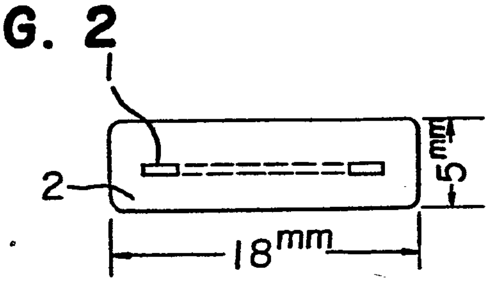


FIG. 3